# EUROPEAN PATENT SPECIFICATION

(11) **EP 1 007 754 B1**
(45) Date of publication and mention of the grant of the patent: **09.10.2002**
(21) Application number: 98936049.0
(22) Date of filing: 29.07.1998
(51) Int. Cl.: C23C 14/00, G02B 1/10

(54) **GLANCING ANGLE DEPOSITION OF THIN FILMS**
AUFDAMPFUNG VON DÜNNEN FILMEN BEI SCHIEFEN EINFALL WINKELN
DEPOT DE MINCES FILMS AVEC ANGLE DE REFLEXION

(30) Priority: 30.07.1997 US 903295; 14.05.1998 CA 2237732
(43) Date of publication of application: 14.06.2000
(73) Proprietor: THE GOVERNORS OF THE UNIVERSITY OF ALBERTA, Edmonton, Alberta T6G 2E1 (CA)
(72) Inventor: ROBBIE, Kevin, J., Edmonton, Alberta T6G 2R4 (CA); BRETT, Michael, J., Edmonton, Alberta T6H 1C4 (CA)
(74) Representative: Robinson, Ian Michael
(86) International application number: CA9800730
(87) International publication number: WO99006608

(56) References cited:
- US-A- 4 336 118
- US-A- 4 874 664

## Description

### FIELD OF THE INVENTION

This invention relates to the deposition of shadow sculpted thin films on substrates.

### BACKGROUND OF THE INVENTION

In the art of growing thin films, it is known to expose a substrate to an oblique incident vapor flux in conditions of limited adatom diffusion and thus grow a columnar microstructure on the substrate.

The optical properties of the resulting microstructure are dependent in part on the material used, the porosity of the microstructure and the orientation of the columns of the thin film.

Hamaguchi et al, United States patent no. 4,874,664, describe lateral shifting or rotation of the position of the substrate in relation to the vapor flux to create uniform film growth and film layers that have columns with different orientations in the different layers. In Hamaguchi et al, the entire substrate is rotated in between periods of exposure of the substrate to vapor flux, or the substrate is laterally shifted during exposure to vapor flux.

A paper of Azzam, "Chiral thin solid films", Appl. Phys. Lett. 61 (26) 28 December 1992, has proposed rotation of the substrate while it is exposed to the oblique incident vapor flux to generate a helical microstructure having helicoidal bianisotropic properties. The proposed rotation of the substrate is about an axis perpendicular to the surface of the substrate, which is referred to in this patent document as rotation about the azimuth, or variation of the azimuthal angle.

The inventors have proposed improvements to the methods of Azzam and Hamaguchi, as described in "First thin film realization of a helicoidal bianisotropic medium", Kevin Robbie and Michael J. Brett, Akhlesh Lakhtakia, J. Vac. Sci. Technol. A 18(6), Nov/Dec 1995, p. 2991 - 2993.

In these references, the relationship of porosity to column angle is fixed, and there has been no way to vary porosity while maintaining the column angle fixed. The present invention seeks to overcome this limitation in the earlier references.

### SUMMARY OF THE INVENTION

There is thus proposed, according to an aspect of the invention, a method of growing vapor deposited thin films, the method comprising the steps of:
A) initially exposing a surface of a substrate to a vapor flux under a given set of growth conditions at an oblique incident angle while rotating the direction of arrival of the vapor flux at the substrate at a rotation speed about a normal to the substrate to grow a first portion of a thin film formed of a plurality of columns growing in a first growth direction;
B) subsequently, and while exposing the surface to vapor flux, altering the set of growth conditions, namely the rotation speed of the direction of arrival of the vapor flux at of the substrate, to cause a second portion of each of the plurality of columns to grow in a growth direction offset from the first growth direction; and
C) repeating steps A and B to create a first thin film formed of columns on the substrate.

During step A, the substrate may be rotated an integral number of times, or, to create a helical pattern, rotated nearly an integral a number of times and paused between periods of rotation at sequentially offset positions.

An optical filter may thus be made with plural thin film layers, wherein each thin film layer is formed by repeating steps A and B.

Preferably, the rotation speed of the direction of arrival of the vapor flux at the substrate during step A is sufficiently high that the direction of arrival of the vapor flux at the substrate rotates at least once within the time required for the thin film to grow a distance, measured normal to the substrate, substantially equal to the adatom diffusion length of the material being deposited.

According to a further aspect of the invention, there is provided a microstructure comprising a first thin film of plural columns extending from a surface of a substrate, wherein the columns are formed under a given set of conditions by vapor deposition on the surface of the substrate from vapor flux incident at an angle θ_{f} to a normal to the surface of the substrate, where 0° < θ_{f} < 90°, the vapor being deposited at least in part while the direction of arrival of the vapor flux at the substrate is rotating, and the columns exhibit the property that 0° < θ_{c} < θₙ where θ_{c} is the angle between the columns and a normal to the surface of the substrate and θₙ is the angle at which the columns would grow under the given set of conditions without rotation of the direction of arrival of the vapor flux at the substrate.

Preferably, the columns are formed at least in part while the direction of arrival of the vapor flux at the substrate is rotating at a rotation speed that is sufficiently high that the direction of arrival of the vapor flux at the substrate rotates at least once within the time required for the thin film to grow a distance, measured normal to the substrate, substantially equal to the adatom diffusion length of the material being deposited.

A second thin film may be formed on top of the first thin film with a different porosity, which may be created by deposition of the second thin film with a different incident angle of vapor flux than the incident angle θ_{f} for the first thin film. The plural thin films may form a continuous stack of thin film layers, one of the plural thin film layers being placed against the top of the first thin film, with each thin film layer having a different porosity from adjacent thin film layers. The thin film may have an refractive index that varies with distance from the substrate.

There is also provided a method of growing vapor deposited thin films, the method comprising the steps of:
exposing a surface of a substrate to a vapor flux at an oblique incident angle while rotating the direction of arrival of the vapor flux at the substrate at a rotation speed about a normal to the substrate to grow a thin film formed of a plurality of columns growing in a first growth direction; and
the rotation speed being sufficiently high that the the direction of arrival of the vapor flux at substrate rotates at least once within the time required for the thin film to grow a distance, measured normal to the substrate, substantially equal to the adatom diffusion length of the material being deposited.

According to a further aspect of the invention, there is provided the step of, while rotating the direction of arrival of the vapor flux at the substrate, varying the oblique incident angle of the vapor flux to vary the density and hence refractive index of the thin film.

According to a further aspect of the invention, the oblique incident angle of vapor flux is varied to produce alternating bands of high and low density material deposited on the substrate.

These and other aspects of the invention are described in the detailed description of the invention and claimed in the claims that follow.

### BRIEF DESCRIPTION OF THE DRAWINGS

There will now be described preferred embodiments of the invention, with reference to the drawings, by way of illustration, in which like numerals denote like elements and in which:
Fig. 1A is a schematic illustrating prior art understanding of how shadow sculpting forms columnar film microstructures;
Figs. 1B-1D show how variation of the flux angle in the prior art may be used to vary column angle and porosity;
Fig. 2 is a graph showing variation of column angle with flux angle of incidence;
Fig. 3 shows schematically a columnar thin film that could not be created conventionally;
Figs. 4 and 5 show a side view of a columnar thin film illustrating how bidirectional flux incidence may be used to overcome the limitation in the prior art illustrated in Fig. 3;
Fig. 6 shows a columnar film that may be made following the principles of the invention;
Fig. 7 is a plan view of a rotating substrate illustrating operation of one aspect of the invention;
Fig. 7A is a graph illustrating variation of time interval between periods of rapid rotation of a substrate about its azimuthal axis, with intervening pausing of substrate rotation;
Fig. 7B is a graph illustrating repeated rapid spinning and paused motion of a substrate;
Fig. 7C shows detail of a column of a thin film formed using the substrate rotation illustrated in Fig. 7A;
Fig. 7D is a graph showing rotation of a substrate with periodically faster and slower rotation speeds;
Fig. 7E is a schematic showing columnar growth resulting from the substrate rotation of Fig. 7D;
Fig. 8 is a perspective showing a novel helix (inner helix) that may be formed according to the invention;
Fig. 9 is a schematic showing apparatus according to one aspect of the invention for depositing a thin film on a substrate using a vapor flux, with an exemplary substrate shown in side view, thereby illustrating how polar angle variation alters the incidence of the vapor flux;
Fig. 10 shows the apparatus of Fig. 9 with the substrate in plan view, thereby illustrating rotation of the substrate about a normal to the plane of the substrate;
Fig. 11 shows control elements for use with the apparatus of Figs. 9 and 10;
Fig. 11A shows an arrangement of the azimuthal and polar angle control motors;
Fig. 12 is a side view of a thin film with helical growths deposited on a substrate with a cap, showing electrodes schematically (the electrodes are not necessarily to scale, since in practice each electrode could cover thousands of helixes);
Fig. 13 is a side view of the microstructure of a thin film with varying density; and
Fig. 14 is a graph showing theoretical and measured spectra of an interference filter with bandwidth 50 nm and reflectance 82%.

### DETAILED DESCRIPTION OF PREFERRED EMBODIMENTS

"Oblique" as used in this patent document in relation to an angle means sufficiently departing from 0° that atomic shadowing has a significant effect on the growth of columnar microstructures. In the case of a rapidly rotating substrate, for low angles of incidence of vapor flux, for example at 0-50°, the resultant thin films do not have particularly useful properties. However, the inventors have found that for angles of incidence of vapor flux greater than 70° and even more so at 80° and greater, the resultant thin films have well defined structures with useful properties. The direction of arrival of an obliquely incident vapor flux at a substrate is the direction in the plane of the substrate obtained by a projection, normal to the substrate, of the angle of incidence onto the substrate. Rotation of the direction of arrival of the vapor flux at the substrate is obtained typically, and most easily, by rotation of the substrate, whereby the direction of arrival of the vapor flux at the substrates rotates around a normal to the substrate. Hence, the invention will be described, in the illustrative embodiment for the case when the substrate itself rotates.

The substrate may be any solid material on which a vapor may be deposited, and will depend on the application. Silicon and glass substrates will be commonly used. The material to be deposited may be any material for which conditions are achievable to support vapor generation and deposition of the vaporized material on the substrate. In some cases, this may require cooling or heating of the substrate. To assist in bonding one vaporized material to another, an intervening layer may be first deposited, as for example using a chromium intermediate layer to bond gold to amorphous silicon dioxide (glass). The processes described here should be carried out in conditions in which the vapor flux arrives at the substrate in approximately a straight line. For this reason, it is preferred that the process be carried out under conditions approximating a vacuum, at less than 0.13N/m² (10⁻³ torr), for example at 1.3x10⁻⁴N/m² (10⁻⁶ torr). At higher pressures, scattering from gas molecules tends to prevent well defined structures from growing. In addition, the material used should have a sticking co-efficient of at least about 0.9 to enable the formation of distinct structures. The growth direction of a column of material is along the axis of the column away from the substrate from which the column is growing. In the case of a helical column, in which the helical structure follows the surface of a hypothetical cylinder, the axis of the column is the axis of the cylinder.

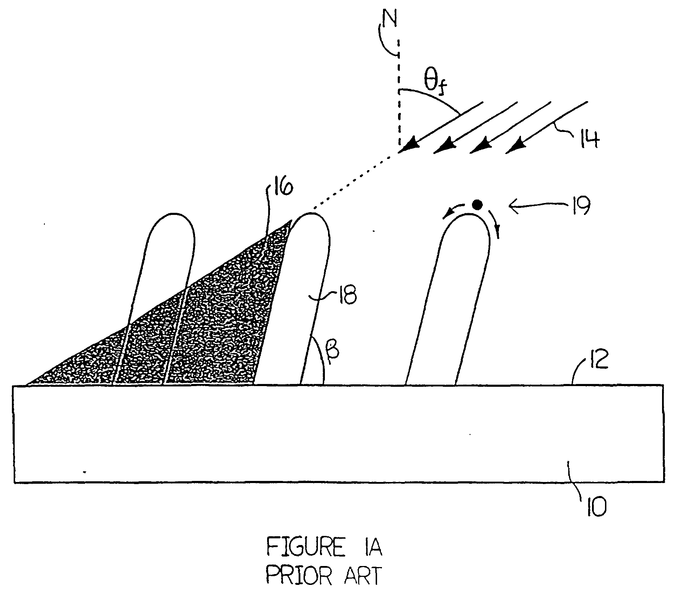

Fig. 1A illustrates the physical process underlying growth of a slanted columnar film microstructure as is known in the prior art. A substrate 10, for example a silicon wafer, has a surface 12 with normal N and is exposed to an oblique incident vapor flux 14 whose angle of incidence, defined in relation to the normal N, is θ_{f}. As atoms in the vapor flux 14 are deposited onto the substrate 10, film growth areas atoms shadow adjacent regions 16, preventing deposition of vapor in these regions. Atoms in the vapor flux 14 continue to be deposited in regions that are not shadowed, thus forming columns 18. Adatoms diffuse atomically across the tops of the columns as shown at 19. Slanted columnar microstructures will grow if the angle θ_{f} is sufficiently large to create the shadowing effect, and there is limited adatom diffusion 19, such that adatom diffusion does not fill in the gaps between columns.

The growth conditions under which a columnar thin film grows on a substrate include the substrate temperature (typically from about 77°K to 600°K), pressure of the vessel in which the vapor deposition takes place, vapor flux intensity (which depends upon the proximity of the vapor source to the substrate and the evaporation rate), vapor flux energy (which depends on the manner in which the vapor flux is created, for example by sputtering or heating), type of material used to produce the vapor flux, for example Cu, MgF₂, CaF₂, SiO, Al, Mn, Cr, Ag, Si, Co, ZrO₂, Ti and Permalloy™ (85% nickel, 15% iron alloy), rotation speed of the substrate, angle of incidence of the vapor flux and the nature of the background gas in the vessel, which is typically maintained at a very low pressure. In general, if no reaction with the background gas is desired, very low pressures are preferred, in which case air may be used as the background gas in most cases. If reaction of the vapor with the background gas is desired, for example in the deposition of SiO₂ instead of SiO_{1.4}, then a background gas comprising O₂ at low pressure is desirable.

In thin film deposition as known in the prior art, there is a fixed relationship between the angle θ_{f} that the vapor flux arrives at the substrate and the angle θ_{c} (90 - β, where β is shown in Fig. 1A) to the substrate normal at which the columnar thin film grows (for a given material and set of deposition conditions). This constraint creates a situation where the columnar orientation and the porosity cannot be controlled independently. If a shallow columnar angle (more parallel to the substrate) is desired, the resulting film must be very porous. Conversely, if a vertical columnar film is desired, the film must be dense. This effect is illustrated in Figures 1B-1D. Fig. 1B shows the situation when the vapor flux arrives straight down onto the substrate θ_{f} = 0°. The resulting film is very dense with a vertical θ_{c} = 0°.

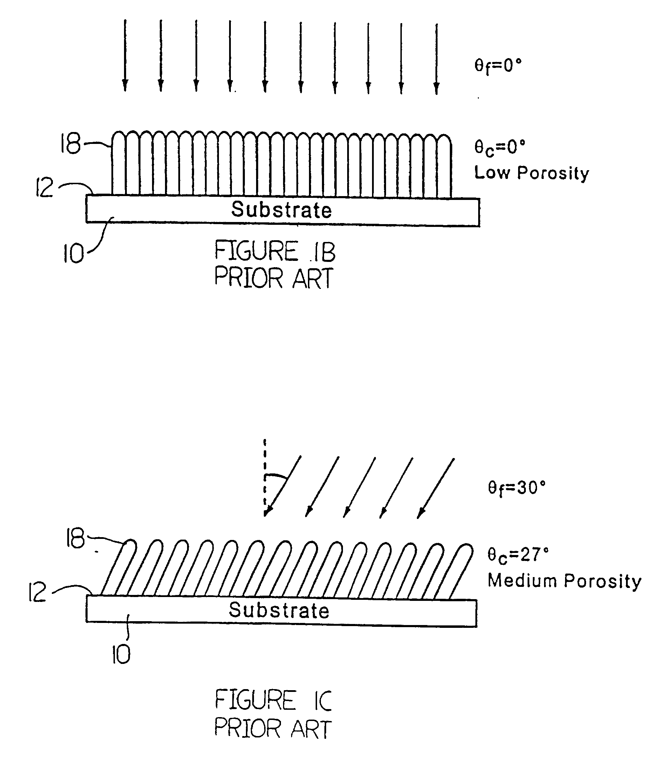

When the flux does not arrive parallel to the substrate normal (θ_{f} > 0°), the columnar film growth is inclined toward the vapor source. The relationship between the flux angle θ_{f} and the column angle θ_{c} is complex, depending on film material, substrate temperature, and other deposition conditions. A simple relationship which provides rough estimates of the column angle from a known flux angle was proposed by Tait et al [Thin Solid Films, 226(1993)]. This relationship may be used as an approximation to describe the column angles for different flux angle conditions. Fig. 1C shows the case where the flux arrives at θ_{f} = 30°. The column angle is θ_{c} = 27° (as calculated with Tait's rule) and the film is somewhat porous. Fig. 1D shows the extreme case where the flux arrives at a highly oblique angle θ_{f} = 80°. The columnar angle is now θ_{c} = 55° and the film is very porous.

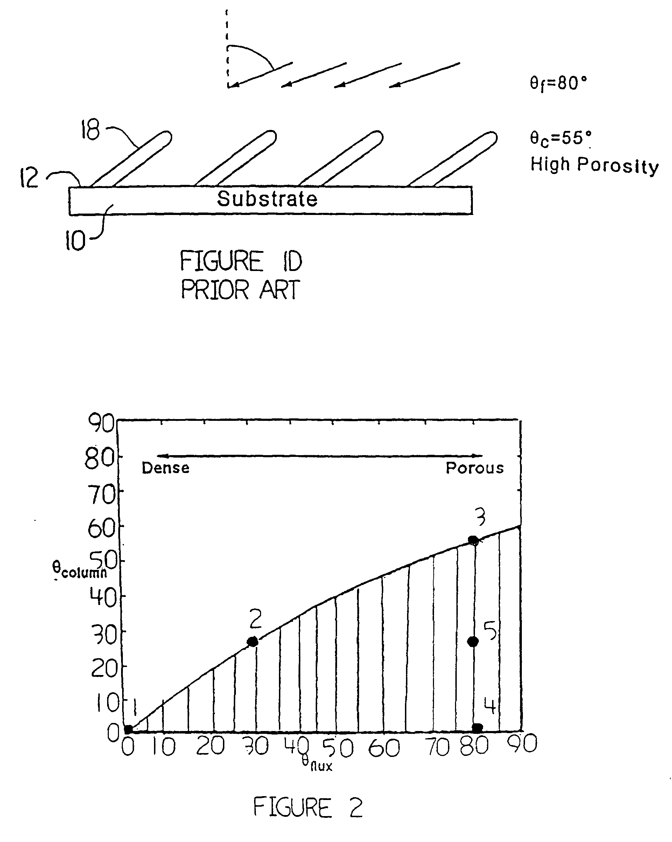

These three results of film structure with incident flux angle are summarized in Fig. 2 where the columnar growth angle is graphed against the vapor flux arrival angle. The solid line is calculated from Tait's rule. Point 1 corresponds to the film shown in Fig. 1B (θ_{f} = 0° and θ_{c} = 0°). Points 2 and 3 correspond to Fig. 1C and 1D respectively. Conventionally, film microstructures are confined to points on this line. For a chosen flux angle, the column angle and porosity are fixed (for a given material and set of deposition conditions).

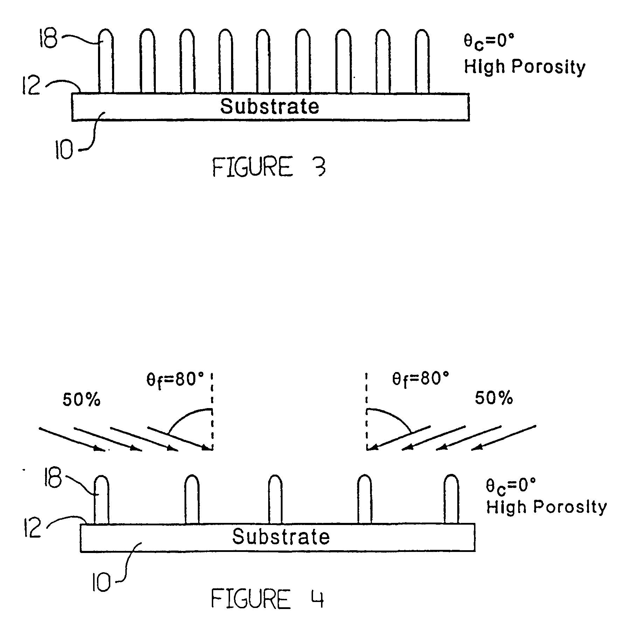

For example, a highly porous film with a vertical columnar structure cannot be produced according to the known prior art. This condition would correspond to point 4 in Fig. 2, and the microstructure is shown in Fig. 3.

This invention describes an improved version of glancing angle deposition (GLAD) which provides a method to circumvent this limitation. While the new technique is based on three-dimensional substrate motion, it is useful for illustration to first describe how a similar effect may be achieved in two dimensions. Fig. 4 shows a method which will allow fabrication of the microstructure shown in Fig. 3 which is believed to be impossible conventionally. With substantially equal amounts of vapor flux arriving onto the substrate from two sides at an oblique angle (θ_{f} = 80°), a porous yet vertical columnar film can be produced. The balanced flux (50%/50%) eliminates the tendency for the columns to be inclined toward the vapor source and the oblique angle produces a porous microstructure.

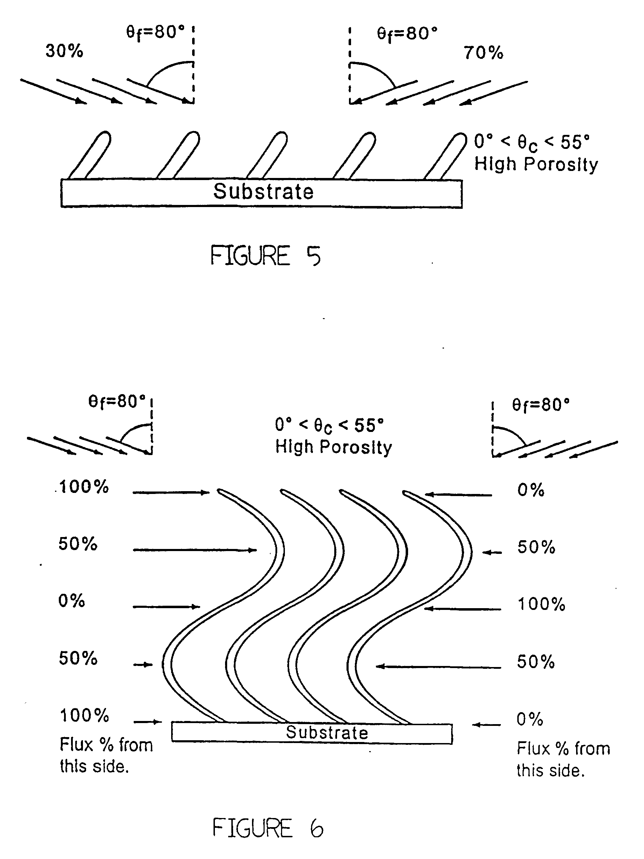

The growth of this film can be thought of as resulting from the sum of the growth caused by the vapor flux from one side and the growth caused by the flux from the other side. To produce a vertical columnar structure, the quantity of the flux from each side is chosen to be substantially equal (50% of the total from each side). Alternately, as seen in Fig. 1D, 100% flux from one side gives a highly inclined structure with θ_{c} ∼ 55° for θ_{f} = 80°. To obtain a column angle between vertical and 55°, the amount of flux from one side is chosen to be between 50% and 100%. Fig. 5 shows this result. With 70% of the flux from one side and 30% of the flux from the other, the column angle is more vertical than with the one sided flux case (100% from one side - Fig. 1D), but not totally vertical (50%/50% case - Fig. 4). With conventional GLAD, film porosity depends on incident flux angle, as does column growth angle, leading to interdependence of these two properties. With the new invention, film porosity still depends on incident flux angle, but column growth angle is now controlled by varying the proportion of flux arriving from each side.

This can be extended by dynamically varying the flux percentages during deposition to achieve much more control over thin film structure than was previously possible. An example of a structure which can be obtained with this procedure is shown in Fig. 6. The amount of flux arriving from the two sides is varied between 0% and 100% as the film grows to produce the desired microstructure. This technique allows the density to remain constant throughout while controlling the columnar angle independently.

An alternate method of forming 'S' shaped columnar structure would be to vary the incident flux angle θ_{f} between oblique (θ = 80°) and normal (θ_{f} = 0°). This would change the column growth angle between θ_{c} = 55° and θ_{c} = 0° but because of the dependence of porosity on incident angle, the film density would vary between high density when θ_{f} = 0° and low density when θ_{f} = 80°.

To extend this technique to deposition in three dimensions, the types of growth must be conceived somewhat differently. Vertical columnar growth of one portion of a thin film is produced by rotating the substrate at a sufficiently high speed that the helical structure normally created during glancing angle deposition of thin films with substrate rotation is functionally eliminated. Complete elimination of the helix may be obtained if the substrate rotates once within the time required for the thin film to grow a distance, measured normal to the substrate, substantially equal to the adatom diffusion length of the material being deposited. The adatom diffusion length may be approximated by the width of a strand of a helix that may be formed during slow or no rotation. Functional elimination of the helix pattern may be obtained at slower rotation speeds if the remaining small helical structure is not detrimental to a specific application. Exemplary diffusion lengths for unheated substrates are: MgF₂ - 60 nm; Cu - 150 nm, Cr - 90 nm, Mn - 80 nm and Al - 100 nm. Substrate rotation at a speed sufficient to functionally eliminate the inherent helical structure may be called spinning growth.

As an example of when the helical structure of the columns is functionally eliminated consider the case of filtering electromagnetic radiation, wherein the electromagnetic radiation includes radiation having a frequency λ and the electromagnetic radiation is propagating along a light path. An optical filter may be placed in the light path, in which the optical filter has plural helical columns extending from a substrate. The effect of the columns is functionally eliminated if the helical columns each have a pitch p sufficiently smaller than that propagation of light is unaffected by the helical structure of the columns. At the same time, the helical columns may have a larger helical geometry or may be arranged with a varying index of refraction that the optical filter has other useful properties that is not dependent on the small scale helical geometry of the columns. In general, the small scale helical columns will not affect light propagation when p < λ/4, particularly when p < λ/10.

Spinning growth effectively provides a flux distribution that is substantially equal from all directions around the substrate while the polar angle θ_{f} remains fixed - analogous to Fig. 4 and the columns grow in a growth direction that is perpendicular to the surface of the substrate. Inclined growth in a growth direction offset from the vertical is produced by altering one of the growing conditions, namely reducing the substrate rotation speed so that the substrate is effectively held in place and not rotating (call this paused growth - analogous to Fig. 1D). Minor deviations from exactly zero rotation speed are permissible, providing the overall effect is to produce an offset growth direction (that is, the growth direction is not the same as during the preceding deposition period). The column then begins to grow conventionally slanted towards the vapor source, though at a steeper angle than θ_{f}. Thus a second portion of the thin film is formed which has a different growth direction than the growth direction in which the portion of the column grows during spinning growth. Repetition of spinning growth and paused growth causes the column to grow with an angle θ_{c} that is less than θₙ, the angle at which the columns would grow under the same growing conditions without rotation of the substrate.

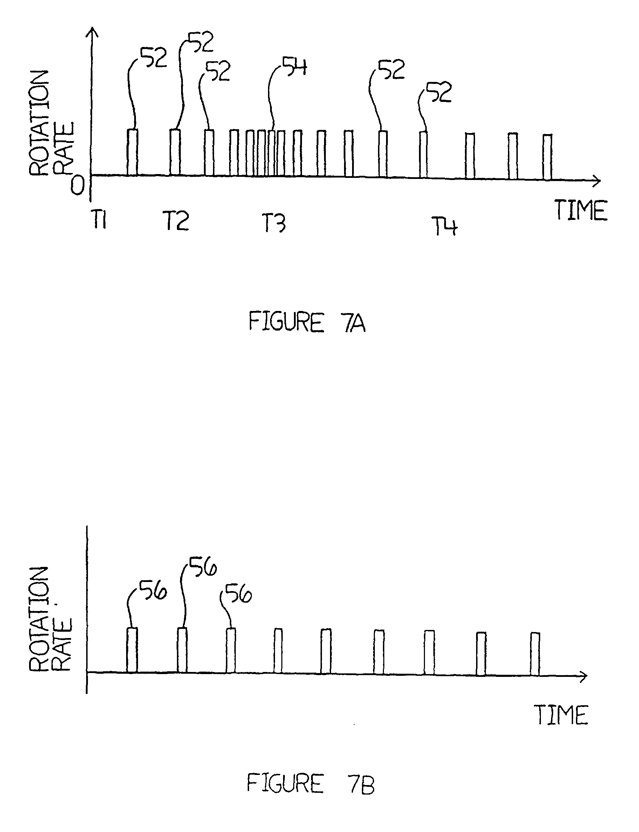

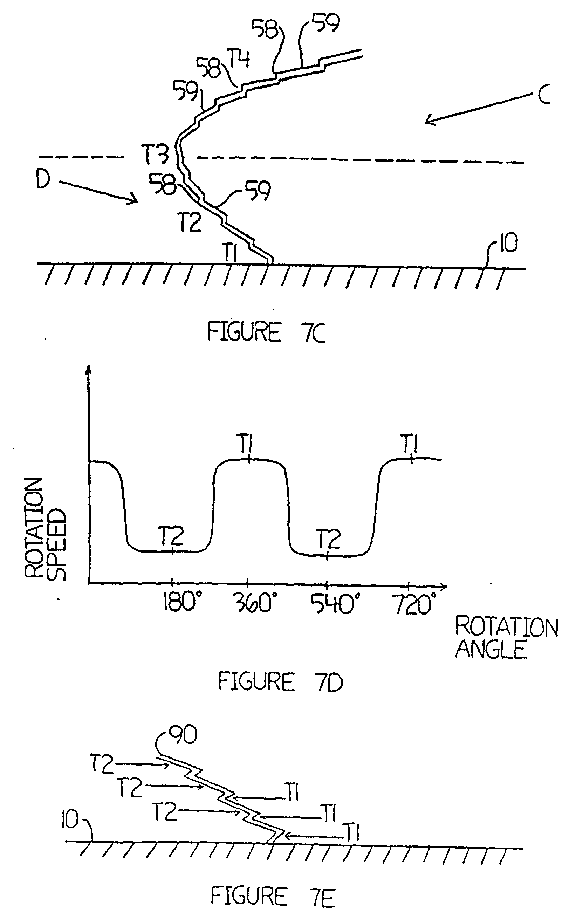

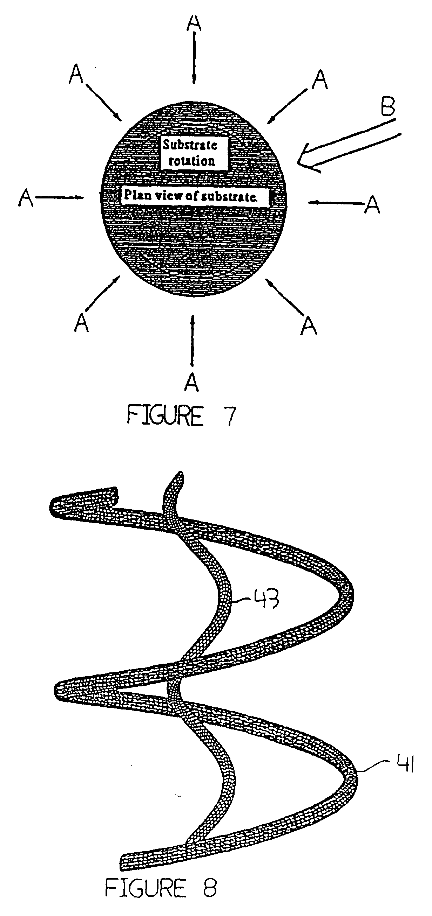

Spinning and paused growth conditions are illustrated with the plan view of the substrate in Fig. 7. The small single arrows A depict the flux arriving from all directions while the substrate is spinning quickly (spinning growth). The double arrow B depicts the second type of growth where the substrate is fixed and a columnar structure inclined toward the vapor source is produced (paused growth). These two types of motion/growth (spinning and paused) are combined to achieve control over the microstructure of the fabricated thin films just as the amount of flux from two sides was used in the two dimensional description above. The way that the combination of these deposition methods is accomplished is by rotating the substrate quickly to produce the spinning growth, but pausing during each revolution to produce the paused growth. Control over the structure comes from choosing how long to pause relative to the time for one revolution and from choosing the pause position. As in the two dimensional example, the type of deposition can be described by the percentage of the flux that arrives during the paused and spinning growth conditions. The substrate is typically rotated an integral number of times, for example, once.

For three dimensional deposition, 100% spinning growth with θ_{f} held at 80° will produce a film with a structure similar to Fig. 4. The spinning growth produces vertical columns and the oblique deposition (θ_{f} = 80°) produces a porous structure. For a deposition with 30% spinning growth and 70% paused growth with the pause position in the same place azimuthally for each pause, a structure similar to Fig. 5 will be produced. The percentages of each of spinning and paused growth can vary between 0% and 100%. Great power of this technique arises when the pause position is not kept the same after each revolution of spinning growth, but is made to precess in a desired way. In this instance, the pause position is slightly azimuthally offset from the previous pause position. The degree of offset affects the radius of the resulting helical structure. A common structure produced with conventional GLAD is a helical columnar film. Before this invention, helical structure was confined by the relationship discussed earlier between deposition angle and columnar angle. If a porous film with helical structure is desired, it must be deposited at an oblique angle (θ_{f} = 80° for example). Conventionally this would mean that the columnar angle would be about θ_{c} = 55° and the column shape would be similar to the outer helix 41 of Fig. 3. The inner helix 43 could not be produced in a porous film. To produce more vertical column angles in the helix would require less oblique flux angles (θ_{f} = 30° for example) and this would result in a denser film.

The realization of this advanced control method has been demonstrated by the inventors. A thin film of MgF₂ was deposited at an oblique angle (θ_{f} = 85°). The film was deposited with the advanced precessing technique with spinning growth (with a pitch of 100nm forming larger helical columns) used for 50% of the deposition time and precessing paused growth (with a pitch of about 1 µm) used for 50% of the deposition time. As predicted, a much more vertical rise angle is obtained (θ_{c} ≅ 15°) and this structure is similar to the inner helix of Fig. 8. This is a structure which could not be obtained with conventional GLAD and demonstrates the ability of the precessional method for controlling thin film microstructures.

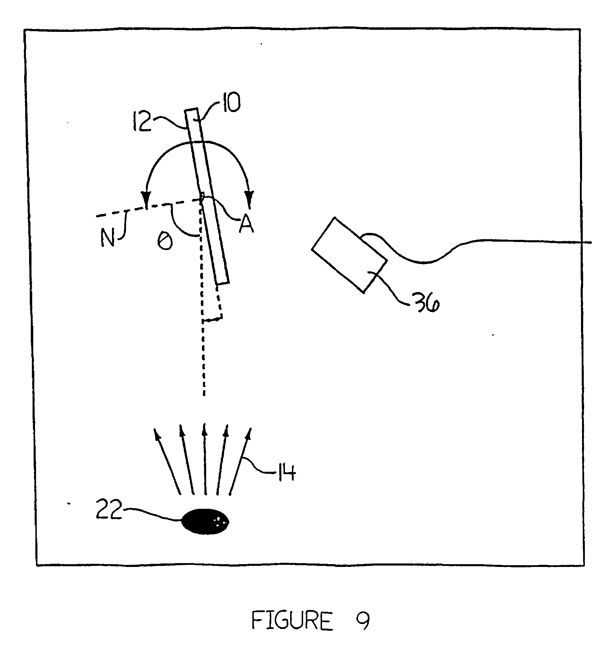

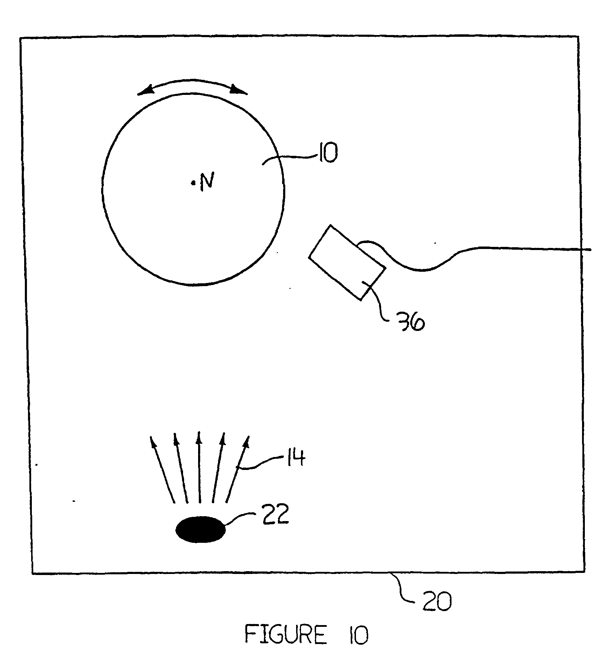

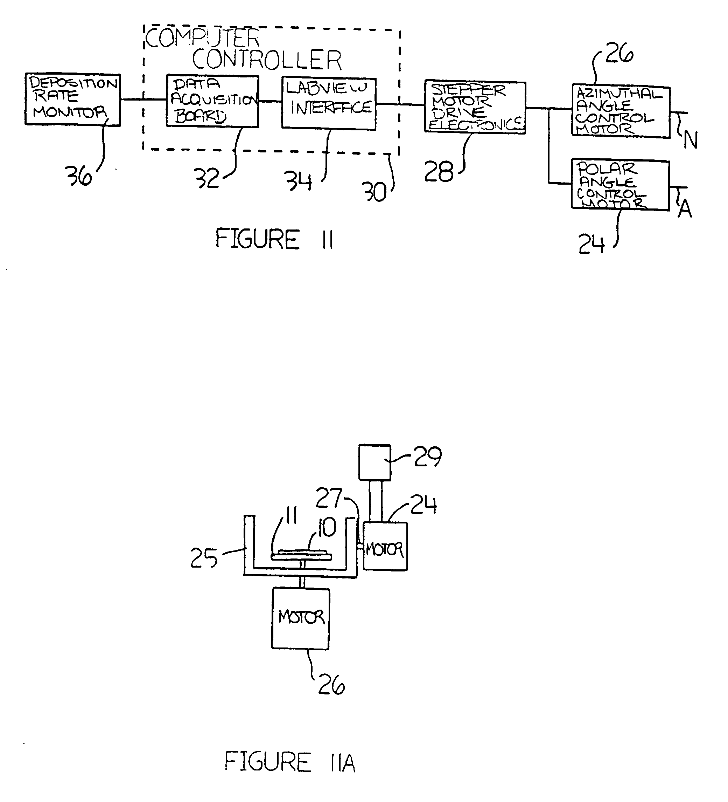

Referring now to Figs. 9, 10 and 11, an apparatus according to the invention is shown for growing a thin film on a substrate 10 having a surface 12. A conventional vapor source 22 is located within a vacuum chamber 20. A conventional shutter (not shown) located above the vapor source 22 is used to control whether or not the substrate 10 is exposed to vapor. Various conventional means (not shown separately) for causing the vapor source 22 to emit a vapor flux 14 may be used. A substrate 10 is supported in the vacuum chamber 20 on a motor 24 (Fig. 11A) disposed in the vacuum chamber 20 above the vapor source 22. The motor 24 rotates the substrate about an axis A lying parallel to and preferably in the plane defined by the surface 12 of the substrate 10. Rotation of the substrate 10 about axis A alters the polar angle, namely the angle of incidence θ of the vapor flux 14. Motor 26, also disposed in the vacuum chamber 20 above the vapor source 22, has a rotational axis coinciding with the normal N of the substrate 10 and thus alters the azimuthal angle. The polar angle and the azimuthal angles are both measures of the orientation of the surface of the substrate to the incident flux.

As shown in Fig. 11A, the substrate 10 is preferably mounted on a disc 11 which is attached to motor 26. Various mounting arrangements of motor 24 and motor 26 may be used. For example, motor 26 may be mounted on a frame 25, and the frame 25 may be mounted to rotate with the drive shaft 27 of motor 24. Motor 24 itself may be mounted by any of various conventional methods for mounting motors within a vacuum chamber such as on a support 29.

Referring now to Fig. 11, motors 24 and 26 are preferably conventional stepper motors driven by stepper motor drive electronics 28 and controlled by computer controller 30. The computer controller 30 includes a data acquisition board 32 and a software based interface 34 such as LabVIEW™ available from National Instruments. Software for implementing the invention is disclosed in applicant's Canadian priority application filed May 16, 1998, as application no. 2,237,732, and is available from WIPO or CIPO after publication or upon request from the inventors at the University of Alberta, Canada. The data acquisition board 32 receives signals indicative of thin film growth on the substrate output from a deposition rate monitor 36 of conventional construction located within the vacuum chamber 20 in a location in which film growth on the deposition rate monitor 36 is representative of film growth on the substrate 10. In response to receiving the output signals from the deposition rate monitor 36, the computer controller 30 instructs the driver 28 to cause the motors 24 and 26 to rotate according to a desired pattern. As described herein, the computer automatically controls the rate of change of the orientation of the surface in response to the output control signals to grow the thin film according to the desired pattern. Start and stop signals for vapor deposition may be sent by the computer to a drive for the shutter for starting vapor deposition, or the shutter may be opened manually. Normally, the motors are started before the shutter opens to initiate deposition.

The software receives a deposition rate from the deposition rate monitor. The actual thickness (T2) of the film growing on the substrate is related to the thickness on the deposition rate monitor by an empirically determined scaling factor known as the tooling factor. The software also knows the motor positions at the last time instant (Xfi for motor 24, Xci for motor 26) and receives as input from the operator, the number (N) of turns to be made by the motor 26, the tooling factor (ratio of vertical film growth rate to measured deposition rate), an initial deposition rate estimate, an initial angle of incidence for the vapor flux during sculpted film growth, motor rotation direction, and various parameters that define the desired pattern of growth for the film. The inputs to the computer establish the desired pattern of film growth.

In an embodiment of the invention, the motors 24, 26 are step motors that rotate a fraction of a circle each time instant, ti, ti+1, ti+2 etc. At any given time ti, the computer has just updated the thickness of the film from the deposition rate monitor 36 and changed the motor step rate so that at ti+1, the motor 24, 26 will be at approximately the desired position according to the desired pattern. Between time instants ti and ti+1, the software calculates what the thickness of the film growth will be at ti+2 and calculates how fast the motors must rotate in order to give the desired thickness at ti+2. At ti+2, the computer then reads the new thickness from the deposition rate monitor as well as the motor stepping rates, and adjusts the motor stepping rate so that at ti+3 the film growth pattern will be approximately as desired. The software continues in this fashion until a stop signal is received, for example when the film has reached a desired thickness.

Algorithms for controlling the motors 24, 26 in the case of spinning and paused growth are illustrated graphically in Figs. 7A-7B and 7D. Rotation speed of the substrate about its normal depends in part on the deposition rate. For MgF₂ at 85° angle of incidence, and a pitch of about 50 nm, the speed is about 2 rpm. Typical rotation speeds used in the process are about 0.2 to 3 rpm.

In Fig. 7A, azimuthal rotation rate of the substrate is plotted against time for the case when the column forms a sinusoidally varying structure as illustrated in Fig. 7C. Times corresponding to points T1-T4 are illustrated on Fig. 7C. During periods of rotation, illustrated by the time segments 52, spinning growth occurs, resulting in the vertical column segments 58 shown in Fig. 7C. The width of the time segments 52 corresponds to the time duration of spinning growth. In between time segments 52, the rotation rate is zero, while the substrate continues to be exposed to vapor flux (paused growth), resulting in the slanted column segments 59. The period between the time segments 52 continually decreases from T1 to T3 and then increases from T3 to T4 in an approximately sinusoidally varying manner. At point T3, time segment 54 corresponds to half a rotation and the pause position switches from the one side to another such that the column begins to grow in a different direction. The half-rotation at T3 corresponds to altering the direction of flux by 180° as illustrated by the arrows C and D in Fig. 7C. In this manner, the column angle θ_{c} varies with distance (measured perpendicularly) from the substrate. Column segments deposited at the same time across a substrate form a layer of a thin film.

In Fig. 7B, azimuthal rotation rate is plotted against time for a helical microstructure that falls within the shaded area of the graph of Fig. 2. Each time segment 56 corresponds to a period of rotation. In between the periods of rotation, the substrate rotation is zero (paused) while the substrate continues to be exposed to vapor flux. The time segments 56 and the intervals between them are constant during deposition. In this instance, the time segment 56 corresponds to a rotation of about 360 ± n°, which results in an offset growth direction for the columns of thin films at an angle that is determined by the azimuthal angle of incidence of the vapor flux. The plus or minus governs the handedness of the helix, and the factor n, which may be for example from 2-10, affects both diameter and pitch of the helical structure. That is, for a given pause/spin relation (say 30% spin and 70% pause as a proportion of time for constant deposition rate), increased precession, ie greater n, will give smaller diameter of the helix and smaller pitch. For a given azimuthal precession of pause position (say 362°), increased pause duration in relation to spin duration, will give larger diameter and smaller pitch. In both cases, the tube diameter of the helix (diameter of the strand forming the helix) should remain fairly constant.

In Fig. 7D, periods of faster rotation (centered about times T1) for example for one half of a rotation and slower rotation (centered about times T2) for another half a rotation are illustrated. The corresponding columnar growth is shown in Fig. 7E, showing the positions on the column 90 corresponding to the times T1 and T2.

It is believed on reasonable grounds that the process will work with any column forming depositable material. Depositable material is column forming when it exhibits limited adatom diffusion and a sufficiently high sticking factor that structures are formed, rather than unformed masses. In the case of MgF₂ thin film formed on a silicon substrate, with S shaped columns, the substrate need not be heated, but the substrate temperature will rise to about 100°C due to heating from the evaporation source. The diffusion length of the MgF₂ under these conditions will be about 40-90 nm. The deposition rate on a monitor near the substrate for flux at normal incidence is about 2-6 nm/s. In this example, fast spinning (spinning growth) occurs at about 3-40 rpm, for a small helical pitch of 10-40 nm. Vacuum pressure for growth in these conditions may be about 1.3x10⁻⁴N/m² (1x10⁻⁶ torr).

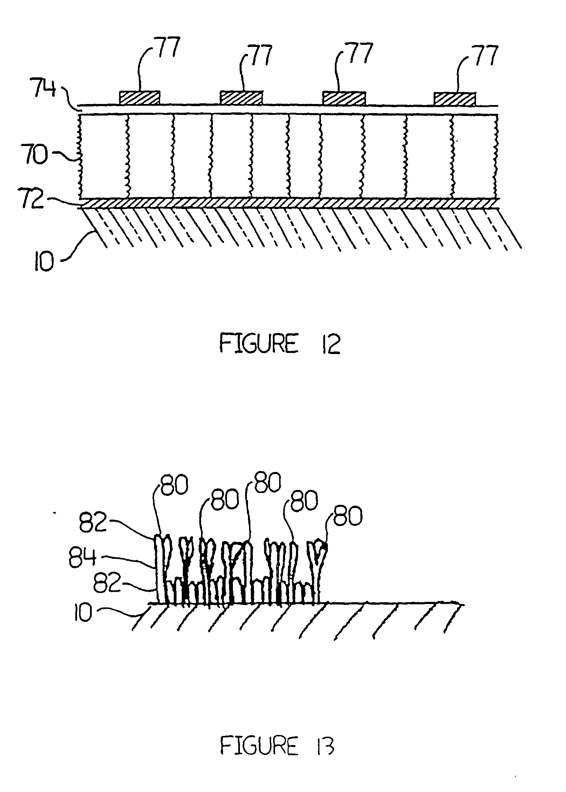

In the preparation of an interference filter according to the principles of the invention, the thin film depositional apparatus illustrated in Figs. 9-11A is used together with the principle of spinning growth. Vapor flux from the evaporation source arrives at the substrate at a glancing angle (θ_{f} > 50°). The substrate position is controlled by the two stepper motors 24 and 26 inside the vacuum deposition system. To generate a film with a density variation with thickness the tilt angle (θ_{f}) is varied proportionally to the desired density variation during deposition. The axial rotation is rapid during the deposition (spinning growth), generating a vertical porous columnar structure and eliminating the helical columnar structure produced by conventional application of GLAD. This deposition process produces an interference filter with index of refraction that varies according to the distance from the substrate, as illustrated in Fig. 13. In Fig. 13, the columns 80 are grown from a substrate 10 with rapid spinning throughout. As the polar angle θ_{f} is varied, the columns 80 produce layers of greater density as shown at 82 and lower density as shown at 84. Layer 82 corresponds to a less oblique incident angle (say 70°) and higher index film, while layer 84 corresponds to a more oblique incident angle (say 85°) and lower index film. The layers thus formed have different densities in adjacent layers. It is believed that by calibrating the density (index) as a function of deposition angle any desired index variation may be generated. The inventors have found that a simple density weighted sum of the index of a thin film material and the index of air was found to predict accurately the effective refractive index as measured with a prism coupler.

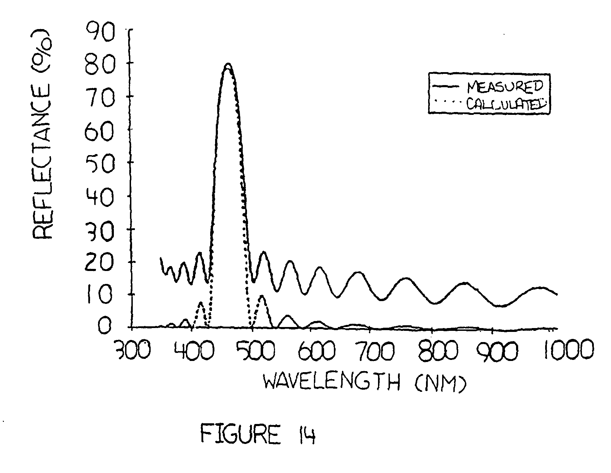

As an example, a film with a sinusoidal variation of refractive index, the tilt angle (θ_{c}) may be varied sinusoidally between 51° and 81° during deposition. The axial rotation is rapid during the deposition, generating a vertical porous columnar structure and eliminating the helical columnar structure produced for other applications of GLAD. This deposition process has been used to produce a MgF₂ rugate filter, whose measured and theoretically predicted reflectance spectrum is shown in Fig. 14.

While the deposition angle variation is sinusoidal, the density as a function of oblique deposition angle is nonlinear and it is expected that the density (index) profile is not truly sinusoidal. The inventors estimate that a rugate filter made with MgF₂ has a density that varies between approximately 90% and 30% of bulk when deposited at θ_{c}=51 and θ_{c}=81 degrees respectively. From the index of MgF₂ and the index of air a rough estimate of the refractive index range in the film may be obtained as between 1.11 and 1.34 (n_{avg} = 1.22, Δn = 0.23). The thickness of the film was measured from an SEM to be approximately 2.6 µm in N=14.5 periods of Λ≅180nm. This thickness value is large for thermally evaporated MgF₂ which typically fractures from stress when deposited thicker than about 1 µm, lending support to the idea that these films have low stress. Using these measured thicknesses, the theoretical reflection spectrum was calculated using a characteristic matrix method (CMM) implemented in FORTRAN. The measured and theoretical reflection spectra are shown in Fig. 14. Fitting the CMM model to the measured spectrum using the known film thickness and estimates of the density variation, shows that the index variation is between 1.13 to 1.31 (n_{avg} = 1.22, Δn = 0.18) in good agreement with the estimates from the film density variation. The measured peak reflectance is R = 82% and the bandwidth is BW = 50 nm centered at about 460 nm. Because the effect of stress is low in these films, the inventors anticipate that very thick filters with correspondingly narrow passbands can be grown. Such filters are of great current interest for wavelength division multiplexing applications in fibre systems.

An optical filter made with a thin film microstructure according to the invention may be tuned using the structure illustrated in Fig. 12. Vapor deposited material extends in distinct (separate from one another) helical columns 70 from an electrode 72 lying on substrate 10. Electrode 72 may also be located on the other side of substrate 10. The distinct helical columns 70 terminating distally from the substrate 10 in a region of denser material forming a cap 74 for the helical columns. The cap 74 may be produced by changing the angle of incidence of the flux from θ near 90° to zero (corresponding to rotation about an axis parallel to the substrate surface), or, it is believed on reasonable grounds that, the deposition of the helical columns may be ended under conditions giving rise to a higher diffusion length, as for example higher substrate temperature or changing to a lower melting point material. Increased substrate temperature may be created by exposing the substrate to light from quartz lamps. Temperatures of within about 100°C to 200°C of the melting point of the material being deposited may be required to create conditions of high diffusion length.

As shown in Fig. 12, plural top electrodes 77 may extend in parallel strips across the top of the cap layer 74 or a single electrode may be formed as a single plate on the top of the cap, or the cap may be formed of electrically conducting material to act as an electrode itself. By applying a charge to the electrodes 72 and 77, the electrodes 72 and 77 may be pulled together or pushed apart and thus change the pitch of the helices 70. This has the effect of tuning the filter created by the thin film.

Uses for thin films with helical growths also include applications in semiconductor integrated circuit fabrication such as very low dielectric insulators for high speed devices, optical filters, electrical delay lines, biological filters, electroluminescent devices, catalyst supports, thermal barrier coatings on high temperature cycling parts such as jet turbine blades, flat panel displays, thermoelectric cooling panels, solar absorbers, adhesive surfaces, electron emitters, tactile sensing for smart skins, magnetic devices, anti-reflection/low dielectric constant coatings, humidity sensing and microfluid pumping systems.

When used as helicoidal bianositropic media, the vapor deposited material should be at least partially transparent at the wavelength of the electromagnetic radiation of interest. The invention is believed to be able to make structures with utility for filtering light having optical, infrared, microwave and millimeter wavelength.

In an alternative embodiment, the direction of arrival of the vapor flux at the substrate may be obtained by sequential operation of plural vapor sources disposed about the substrate. For this operation, it is convenient to use sputtering devices for the vapor sources. The vapor sources may be located around a hemi-spherical enclosure disposed above a substrate. For example, there may be a single source at the apex of the enclosure, with several, eg four, sources disposed in each of several layers or rings of sources disposed further outward and downward from the apex. Sources in adjacent layers may be offset from each other. The sources may then be operated (turned on and off) sequentially to cause the vapor to arrive at different directions of arrival. The direction of arrival of the vapor flux at the substrate may be rotated in this fashion about a normal to the substrate or the angle of incidence may be changed. Other ways of accomplishing the variation in direction of arrival of the vapor flux at the substrate in accordance with the principles of the invention may occur to a person skilled in the art and these are intended to be covered by the claims that follow.

## Claims

1. A method of growing vapor deposited thin films, the method comprising the steps of:
A) initially exposing a surface of a substrate to a vapor flux under a given set of growth conditions at an oblique incident angle while rotating the direction of arrival of the vapor flux at the substrate at a rotation speed about a normal to the substrate to grow a first portion of a thin film formed of a plurality of columns growing in a first growth direction;
B) subsequently, and while exposing the surface to vapor flux, altering the set of growth conditions to cause a second portion of each of the plurality of columns to grow in a growth direction offset from the first growth direction; and
C) repeating steps A and B to create a first thin film formed of columns on the substrate.

2. The method of claim 1 in which altering the set of growth conditions comprises changing the rotation speed of the direction of arrival of the vapor flux at the substrate.

3. The method of claim 2 in which altering the set of growth conditions comprises reducing the rotation speed of the direction of arrival of the vapor flux at the substrate.

4. The method of claim 2 in which, in each repetition of step A, the direction of arrival of the vapor flux at the substrate is rotated an integral number of times.

5. The method of claim 2 in which, in each step B except an initial step B, the growth direction is offset from the growth direction in the preceding step B.

6. The method of claim 2 in which, in each step A, the first growth direction is perpendicular to the surface of the substrate.

7. The method of claim 6 in which, in each step B except an initial step B, the growth direction is offset from the growth direction in the preceding step B.

8. The method of claim 2 in which the first thin film formed by repetition of steps A and B has a first porosity, and the method further comprises:
repeating steps A and B under different growing conditions to grow a second thin film on the first thin film wherein the second thin film has a second porosity different from the first porosity.

9. The method of claim 8 further comprising forming an optical filter with plural thin film layers, wherein each thin film layer is formed by repeating steps A and B.

10. The method of claim 2 in which the rotation speed of the direction of arrival of the vapor flux at the substrate during step A is sufficiently high that the direction of arrival of the vapor flux at the substrate rotates at least once within the time required for the thin film to grow a distance, measured normal to the substrate, substantially equal to the adatom diffusion length of the material being deposited.

11. The method of claim 2 in which a thin film with graded density is made by repeating steps A and B under varying growing conditions.

12. The method of claim 1 in which the substrate is rotated.

13. A microstructure comprising a first thin film of plural columns extending from a surface of a substrate, wherein the columns are formed under a given set of conditions by vapor deposition on the surface of the substrate from vapor flux incident at an angle θ_{f} to a normal to the surface of the substrate, where 0° < θ_{f} < 90°, the vapor being deposited at least in part while the direction of arrival of the vapor flux at the substrate is rotating, and the columns exhibit the property that 0° < θ_{c} < θₙ where θ_{c} is the angle between the columns and a normal to the surface of the substrate and θₙ is the angle at which the columns would grow under the given set of conditions without rotation of the direction of arrival of the vapor flux at the substrate.

14. The microstructure of claim 13 in which the columns are formed at least in part while the direction of arrival of the vapor flux at the substrate is rotating at a rotation speed that is sufficiently high that the substrate rotates at least once within the time required for the thin film to grow a distance, measured normal to the substrate, substantially equal to the adatom diffusion length of the material being deposited.

15. The microstructure of claim 13 in which the first thin film has a first porosity and further comprising a second thin film formed on top of the first thin film, the second thin film having a second porosity that is different from the first porosity.

16. The microstructure of claim 15 in which the density of the second thin film is different from the first thin film due to a deposition of the second thin film with a different incident angle of vapor flux than the incident angle θ_{f} for the first thin film.

17. The microstructure of claim 15 further comprising plural thin film layer, one of the plural thin film layers commencing at the top of the first thin film, with each thin film layer having a different porosity from adjacent thin film layers.

18. The microstructure of claim 14 in which the thin film has a refractive index that varies with distance from the substrate.

19. A method of growing vapor deposited thin films, the method comprising the steps of:
exposing a surface of a substrate to a vapor flux at an oblique incident angle greater than 70° while rotating the direction of arrival of the vapor flux at the substrate at a rotation speed about a normal to the substrate to grow a thin film formed of a plurality of columns growing in a first growth direction; and
the rotation speed being sufficiently high that the direction of arrival of the vapor flux at the substrate rotates at least once within the time required for the thin film to grow a distance, measured normal to the substrate, substantially equal to the adatom diffusion length of the material being deposited.

20. The method of claim 19 further comprising:
while rotating the direction of arrival of the vapor flux at the substrate, varying the oblique incident angle of the vapor flux to vary the density and hence refractive index of the thin film.

21. The method of claim 20 in which the oblique incident angle of vapor flux is varied to produce alternating bands of high and low density material deposited on the substrate.

22. A method of growing a vapor deposited thin film on a substrate, wherein the thin film is formed of columns, the method comprising the steps of:
exposing a surface of a substrate to a first vapor flux having a first intensity arriving at the substrate at a first oblique incident angle;
exposing the surface of the substrate to a second vapor flux having a second intensity, the second vapor flux arriving at the substrate at a second oblique incident angle which is azimuthally offset from the first oblique incident angle; and
either (A) the first vapor flux and second vapor fluxes are sourced from the same vapor source at different times at oblique incident angles greater than 70° or (B) the first and second vapor fluxes are formed from the same material from two different sources which contribute unequal amounts of flux, whereby the first and second vapor fluxes combine to grow a thin film formed of a plurality of columns growing in a growth direction.

23. The method of claim 22 further comprising varying the contribution of flux from different directions to alter the growth direction.

24. The method of claim 23 in which varying the contribution of flux comprises rotating the substrate at varying rotation speeds.

## Patentansprüche

1. Verfahren zum Züchten von durch Aufdampfen erzeugten Dünnschichten, welches die folgenden Schritte aufweist:
A) Anfangs wird die Oberfläche eines Substrates einem Dampfstrom unter einer gegebenen Gruppe von Wachstumsbedingungen mit einem schiefen Einfallswinkel ausgesetzt, während die Richtung des Auftreffens des Dampfstromes auf das Substrat mit einer Umlaufgeschwindigkeit um eine Normale zum Substrat rotiert, um einen ersten Anteil einer Dünnschicht zu züchten, der durch eine Vielzahl von Säulen gebildet ist, die in eine erste Wachstumsrichtung wachsen.
B) Anschließend hierzu, während die Oberfläche dem Dampfstrom ausgesetzt ist, wird die Gruppe von Wachstumsbedingungen verändert, um einen zweiten Anteil jeder der Vielzahl von Säulen zum Wachsen in eine Wachstumsrichtung zu veranlassen, die zur ersten Wachstumsrichtung versetzt ist.
C) Wiederholung der Schritte A und B, um eine erste Dünnschicht in Form von Säulen auf dem Substrat zu erzeugen.

2. Verfahren nach Anspruch 1, bei dem das Verändern der Gruppe von Wachstumsbedingungen es einschließt, die Umlaufgeschwindigkeit der Richtung des Auftreffens des Dampfstromes auf das Substrat zu verändern.

3. Verfahren nach Anspruch 2, bei dem das Verändern der Gruppe von Wachstumsbedingungen es einschließt, die Umlaufgeschwindigkeit der Richtung des Auftreffens des Dampfstromes auf das Substrat zu reduzieren.

4. Verfahren nach Anspruch 2, bei dem man bei jeder Wiederholung des Schrittes A, die Richtung des Auftreffens des Dampfstromes auf das Substrat eine ganzzahlige Anzahl von Malen umlaufen lässt.

5. Verfahren nach Anspruch 2, bei dem bei jedem Schritt B, außer dem anfänglichen Schritt B, die Wachstumsrichtung gegenüber der Wachstumsrichtung des vorangegangenen Schrittes B versetzt wird.

6. Verfahren nach Anspruch 2, bei dem bei jedem Schritt A die erste Wachstumsrichtung rechtwinklig zur Oberfläche des Substrates verläuft.

7. Verfahren nach Anspruch 6, bei dem bei jedem Schritt B, außer dem anfänglichen Schritt B, die Wachstumsrichtung gegenüber der Wachstumsrichtung des vorangegangenen Schrittes B versetzt wird.

8. Verfahren nach Anspruch 2, bei dem die erste Dünnschicht, welche durch Wiederholung der Schritte A und B gebildet wurde, eine erste Porösität hat und das Verfahren es weiterhin beinhaltet, dass die Schritte A und B unter verschiedenen Wachstumsbedingungen wiederholt werden, so dass eine zweite Dünnschicht auf der ersten Dünnschicht wächst, wobei die zweite Dünnschicht eine zweite Porösität hat, die sich von der ersten Porösität unterscheidet.

9. Verfahren nach Anspruch 8, welches des Weiteren die Bildung eines optischen Filters mit einer Vielzahl von Dünnschichtlagen einschließt, wobei jede der Dünnschichtlagen durch Wiederholung der Schritte A und B gebildet wird.

10. Verfahren nach Anspruch 2, bei dem die Umlaufgeschwindigkeit der Auftreffrichtung des Dampfstromes auf das Substrat während des Schrittes A ausreichend hoch ist, dass die Auftreffrichtung des Dampfstromes auf das Substrat zumindest einmal innerhalb der Zeit rotiert, die zum Wachsen der Dünnschicht um einen Abstand erforderlich ist, der normal zum Substrat gemessen wird und im Wesentlichen gleich mit der Diffusionslänge des Adsorptionsatoms des abgeschiedenen Materials ist.

11. Verfahren nach Anspruch 2, bei dem eine Dünnschicht mit abgestufter Dichte durch Wiederholung der Schritte A und B unter wechselnden Wachstumsbedingungen erzeugt wird.

12. Verfahren nach Anspruch 1, bei dem das Substrat gedreht wird.

13. Mikrostruktur, welche eine erste Dünnschicht mit einer Vielzahl von Säulen aufweist, die sich von einer Oberfläche eines Substrates erstrecken, wobei die Säulen unter einer festgelegten Gruppe von Bedingungen durch Aufdampfen auf die Oberfläche des Substrates aus einem Dampfstrom gebildet sind, der mit einem Winkel von θ_{f} zu einer Normalen zur Oberfläche des Substrates einfällt, wobei 0° < θ_{f} < 90° ist, und der Dampf zumindest teilweise abgeschieden wird, während die Richtung des Auftreffens des Dampfstromes auf das Substrat rotiert, und wobei die Säulen das Merkmal aufweisen, dass 0° < θ_{c} < θₙ ist, wenn θ_{c} der Winkel zwischen den Säulen und einer Normalen zur Oberfläche des Substrates ist und wenn θₙ der Winkel ist, unter welchem die Säulen unter der gegebenen Gruppe von Bedingungen ohne Umlauf der Richtung des Auftreffens des Dampfstromes auf das Substrat wachsen würden.

14. Mikrostruktur nach Anspruch 13, bei der die Säulen zumindest teilweise gebildet werden, während die Auftreffrichtung des Dampfstromes auf das Substrat mit einer Umlaufgeschwindigkeit rotiert, die ausreichend hoch ist, dass das Substrat zumindest einmal innerhalb der Zeit rotiert, die zum Wachsen der Dünnschicht um einen Abstand erforderlich ist, der normal zum Substrat gemessen wird und im Wesentlichen gleich mit der Diffusionslänge des Adsorptionsatoms des abgeschiedenen Materials ist.

15. Mikrostruktur nach Anspruch 13, bei der die erste Dünnschicht eine erste Porösität hat und bei der weiterhin eine zweite Dünnschicht vorhanden ist, die auf der ersten Dünnschicht gebildet ist, wobei die zweite Dünnschicht eine zweite Porösität hat, die sich von der ersten Porösität unterscheidet.

16. Mikrostruktur nach Anspruch 15, bei der die Dichte der zweiten Dünnschicht von der der ersten Dünnschicht aufgrund eines Abscheidens der zweiten Dünnschicht mit gegenüber dem Einfallswinkel θ_{f} für die erste Dünnschicht unterschiedlichem Einfallswinkel des Dampfstromes verschieden ist.

17. Mikrostruktur nach Anspruch 15, welche des Weiteren mehrere Dünnschichtlagen enthält, wobei eine der vielen Dünnschichtlagen oben auf der ersten Dünnschicht anfängt und jede Dünnschichtlage eine unterschiedliche Porösität gegenüber angrenzenden Dünnschichtlagen hat.

18. Mikrostruktur nach Anspruch 14, bei der die Dünnschicht einen Brechungsindex hat, der sich mit dem Abstand von dem Substrat verändert.

19. Verfahren zum Züchten von durch Aufdampfen erzeugten Dünnschichten, welches die folgenden Schritte aufweist:
Die Oberfläche eines Substrates wird einem Dampfstrom bei einem schiefen Einfallswinkel von über 70° ausgesetzt, während die Auftreffrichtung des Dampfstromes auf das Substrat mit einer Umlaufgeschwindigkeit um eine Normale zum Substrat rotiert, so dass eine Dünnschicht wächst, die durch eine Vielzahl von in eine erste Wachstumsrichtung wachsenden Säulen gebildet ist.
Die Umlaufgeschwindigkeit ist ausreichend hoch, dass die Auftreffrichtung des Dampfstromes auf das Substrat zumindest einmal innerhalb der Zeit rotiert, die zum Wachsen der Dünnschicht um einen Abstand erforderlich ist, der normal zum Substrat gemessen wird und im Wesentlichen gleich mit der Diffusionslänge des Adsorptionsatoms des abgeschiedenen Materials ist.

20. Verfahren nach Anspruch 19, bei dem während des Umlaufens der Auftreffrichtung des Dampfstromes auf das Substrat der schiefe Einfallswinkel des Dampfstromes verändert wird, um die Dichte und damit den Brechungsindex der Dünnschicht zu verändern.

21. Verfahren nach Anspruch 20, bei dem der schiefe Einfallswinkel des Dampfstromes verändert wird, um wechselnde Streifen von auf dem Substrat abgeschiedenem Material mit hoher und geringer Dichte zu produzieren.

22. Verfahren zum Züchten einer durch Aufdampfen erzeugten Dünnschicht auf einem Substrat, bei dem die Dünnschicht durch Säulen gebildet ist, wobei das Verfahren aus folgenden Schritten besteht:
Die Oberfläche eines Substrates wird einem ersten Dampfstrom einer ersten Stärke ausgesetzt, der auf das Substrat mit einem ersten, schiefen Einfallswinkel auftrifft.
Die Oberfläche des Substrates wird einem zweiten Dampfstrom einer zweiten Stärke ausgesetzt, wobei der zweite Dampfstrom mit einem zweiten, schiefen Einfallswinkel auf das Substrat auftrifft, der einen Azimutalversatz zu dem ersten, schiefen Einfallswinkel aufweist.
Entweder stammen (A) der erste Dampfstrom und der zweite Dampfstrom zu unterschiedlichen Zeiten und mit schiefem Einfallswinkel von über 70° von derselben Dampfquelle oder (B) der erste Dampfstrom und der zweite Dampfstrom werden aus demselben Material aus unterschiedlichen Quellen erzeugt, die zu einer ungleichen Stromstärke beitragen, wobei der erste und zweite Dampfstrom sich vereinen, um eine Dünnschicht wachsen zu lassen, die aus einer Vielzahl von in eine Wachstumsrichtung wachsenden Säulen gebildet ist.

23. Verfahren nach Anspruch 22, welches es weiterhin beinhaltet, dass der Anteil des Stromes aus verschiedenen Richtungen verändert wird, um die Wachstumsrichtung zu verändern.

24. Verfahren nach Anspruch 23, bei dem das Verändern des Anteils des Stromes es beinhaltet, dass das Substrat mit unterschiedlichen Umlaufgeschwindigkeiten rotiert.

## Revendications

1. Procédé de croissance de films minces déposés en phase vapeur, ledit procédé comprenant les étapes suivantes :
A) l'exposition initiale d'une surface d'un substrat à un flux de vapeur sous un jeu donné de conditions de croissance selon un angle incident oblique tout en faisant tourner la direction d'arrivée du flux de vapeur au niveau du substrat autour d'une direction approximativement normale au substrat, selon une vitesse de rotation, pour faire croître une première portion d'un film mince formé d'une pluralité de colonnes croissant selon une première direction de croissance ;
B) ultérieurement, et tout en exposant la surface au flux de vapeur, à modifier le jeu de conditions de croissance pour provoquer la croissance d'une seconde portion de chacune de la pluralité de colonnes dans une direction de croissance décalée par rapport à la première direction de croissance ; et
C) répéter les étapes A et B pour créer un premier film mince formé de colonnes sur le substrat.

2. Procédé selon la revendication 1, dans lequel la modification du jeu de conditions de croissance comprend le changement de la vitesse de rotation de la direction d'arrivée du flux de vapeur au niveau du substrat.

3. Procédé selon la revendication 2, dans lequel la modification du jeu de conditions de croissance comprend la réduction de la vitesse de rotation de la direction d'arrivée du flux de vapeur au niveau du substrat.

4. Procédé selon la revendication 2, dans lequel, dans chacune des répétitions de l'étape A, la direction d'arrivée du flux de vapeur au niveau du substrat est tournée d'un nombre entier de fois.

5. Procédé selon la revendication 2, dans lequel, dans chaque étape B, à l'exception de l'étape initiale B, la direction de croissance est décalée de la direction de croissance de l'étape B précédente.

6. Procédé selon la revendication 2, dans lequel, dans chaque étape A, la première direction de croissance est perpendiculaire à la surface du substrat.

7. Procédé selon la revendication 6, dans lequel, dans chaque étape B, à l'exception de l'étape initiale B, la direction de croissance est décalée de la direction de croissance de l'étape B précédente.

8. Procédé selon la revendication 2, dans lequel le premier film mince formé par répétitions des étapes A et B a une première porosité, et le procédé comprenant en outre :
la répétition des étapes A et B sous différentes conditions de croissance pour faire croître un second film mince sur le premier film mince, ledit second film mince ayant une seconde porosité différente de la première porosité.

9. Procédé selon la revendication 8, comprenant en outre la formation d'un filtre optique avec plusieurs couches de film mince, chaque couche de film mince étant formée en répétant les étapes A et B.

10. Procédé selon la revendication 2, dans lequel la vitesse de rotation de la direction d'arrivée du flux de vapeur au niveau du substrat pendant l'étape A est suffisamment élevée pour que la direction d'arrivée du flux de vapeur au niveau du substrat tourne au moins une fois au cours du temps nécessaire au film mince pour croître sur une distance, telle que mesurée selon une direction normale au substrat, sensiblement égale à la longueur de diffusion adatome du matériau en cours de dépôt.

11. Procédé selon la revendication 2, dans lequel un film mince de densité étagée est réalisé en répétant les étapes A et B dans des conditions de croissance variantes.

12. Procédé selon la revendication 1, dans lequel on fait tourner le substrat.

13. Microstructure comprenant un premier film mince d'une pluralité de colonnes s'étendant depuis une surface d'un substrat, microstructure dans laquelle les colonnes sont formées sous un jeu donné de conditions par dépôt en phase vapeur sur la surface du substrat depuis un flux de vapeur incident selon un angle θ_{f} par rapport à la direction normale à la surface du substrat, où 0°< θ_{f} < 90°, la vapeur étant déposée au moins en partie tandis que la direction d'arrivée du flux de vapeur au niveau du substrat est tournante, et les colonnes manifestant la propriété 0° < θ_{c} < θₙ où θ_{c} est l'angle entre les colonnes et la direction normale à la surface du substrat et θₙ est l'angle selon lequel les colonnes croîtraient sous le jeu donné de conditions sans rotation de la direction d'arrivée du flux de vapeur au niveau du substrat.

14. Microstructure selon la revendication 13, dans laquelle les colonnes sont formées au moins en partie tandis que la direction d'arrivée du flux de vapeur au niveau du substrat tourne à une vitesse de rotation qui est suffisamment élevée pour que le substrat tourne au moins une fois au cours du temps nécessaire au film mince pour croître sur une distance, mesurée selon une direction normale au substrat, sensiblement égale à la longueur de diffusion adatome du matériau en cours de dépôt.

15. Microstructure selon la revendication 13, dans lequel le premier film mince a une première porosité, ladite microstructure comprenant en outre un second film mince formé sur le dessus du premier film mince, le second film mince ayant une seconde porosité qui diffère de la première porosité.

16. Microstructure selon la revendication 15, dans laquelle la densité du second film mince diffère de celle du premier film mince en raison d'un dépôt du second film mince selon un angle incident du flux de vapeur qui diffère de l'angle incident θ_{f} pour le premier film mince.

17. Microstructure selon la revendication 15, comprenant en outre une pluralité de couches de film mince, l'une de ladite pluralité de couches de film mince commençant au niveau du sommet du premier film mince, chaque couche de film mince ayant une porosité qui diffère de la porosité des couches de film mince adjacentes.

18. Microstructure selon la revendication 14, dans laquelle le film mince a un indice de réfraction qui varie avec la distance du substrat.

19. Procédé de croissance de films minces déposés en phase vapeur, ledit procédé comprenant les étapes suivantes :
l'exposition d'une surface d'un substrat à un flux de vapeur selon un angle incident oblique supérieur à 70° tout en faisant tourner la direction d'arrivée du flux de vapeur au niveau du substrat autour d'une direction normale au substrat, à une vitesse de rotation, pour faire croître un film mince formé d'une pluralité de colonnes croissant selon une première direction de croissance ; et
la vitesse de rotation étant suffisamment élevée pour que la direction d'arrivée du flux de vapeur au niveau du substrat tourne au moins une fois au cours du temps nécessaire au film mince pour croître d'une distance, mesurée selon une direction normale au substrat, sensiblement égale à la longueur de diffusion adatome du matériau en cours de dépôt.

20. Procédé selon la revendication 19, comprenant en outre :
tout en faisant tourner la direction d'arrivée du flux de vapeur au niveau du substrat, la variation de l'angle incident oblique du flux de vapeur pour faire varier la densité et par conséquent l'indice de réfraction du film mince.

21. Procédé selon la revendication 20, dans lequel l'angle incident oblique du flux de vapeur varie pour produire des bandes alternantes de matériau de densités élevée et faible déposé sur le substrat.

22. Procédé de croissance d'un film mince déposé en phase vapeur sur un substrat, dans lequel le film mince est formé de colonnes, ledit procédé comprenant les étapes suivantes :
l'exposition d'une surface d'un substrat à un premier flux de vapeur ayant une première intensité arrivant au niveau du substrat selon un premier angle incident oblique ;
l'exposition de la surface du substrat à un second flux de vapeur ayant une seconde intensité, le second flux de vapeur arrivant au niveau du substrat selon un second angle incident oblique qui est décalé azimutalement par rapport au premier angle incident oblique ; et
soit (A) le premier flux de vapeur et le second flux de vapeur proviennent de la même source de vapeur à des moments différents selon des angles incidents obliques supérieurs à 70°, soit (B) les premier et second flux de vapeur sont formés à partir du même matériau provenant de deux sources différentes qui fournissent des quantités inégales de flux, grâce à quoi les premier et second flux de vapeur se combinent pour faire croître un film mince formé d'une pluralité de colonnes croissant dans une direction de croissance.

23. Procédé selon la revendication 22, comprenant en outre la variation de la contribution de flux provenant de différentes directions pour modifier la direction de croissance.

24. Procédé selon la revendication 23, dans lequel la variation de la contribution de flux comprend la rotation du substrat à des vitesses de rotation variantes.
